# EUROPEAN PATENT SPECIFICATION

(11) **EP 2 484 008 B1**
(45) Date of publication and mention of the grant of the patent: **10.08.2016**
(21) Application number: 10821619.3
(22) Date of filing: 27.09.2010
(51) Int. Cl.: H03H 9/02, H03H 3/007, H03H 3/013, H03H 9/24, H03H 3/02, H03H 3/04, B81B 7/00, B81B 3/00

(54) **A MICROMECHANICAL RESONATOR**
MIKROMECHANISCHER RESONATOR
RÉSONATEUR MICROMÉCANIQUE ET SON PROCÉDÉ DE FABRICATION

(30) Priority: 28.09.2009 FI 20095988
(43) Date of publication of application: 08.08.2012
(73) Proprietor: Teknologian tutkimuskeskus VTT Oy, 02150 Espoo (FI)
(72) Inventor: OJA, Aarne, FI-02044 Vtt (FI); PENSALA, Tuomas, FI-02044 Vtt (FI); MELTAUS, Johanna, FI-02044 Vtt (FI)
(74) Representative: Seppo Laine Oy
(86) International application number: PCT/FI2010/050744
(87) International publication number: WO 2011/042597

(56) References cited:
- EP-A2- 1 313 216
- WO-A1-2008/043727
- WO-A2-2007/072409
- US-A1- 2005 195 050
- US-A1- 2007 188 269
- US-A1- 2008 204 173
- US-A1- 2009 158 566
- US-A1- 2010 032 789
- US-B1- 7 591 201
- US-B1- 7 639 104
- NAMRATA DEWAN ET AL: "Temperature-Compensated Devices Using Thin TeO Layer With Negative TCD", IEEE ELECTRON DEVICE LETTERS, IEEE SERVICE CENTER, NEW YORK, NY, US, vol. 27, no. 9, 1 September 2006 (2006-09-01), pages 752-754, XP001546738, ISSN: 0741-3106, DOI: 10.1109/LED.2006.880644
- SCHOEN F. ET AL: 'Temperature compensation in silicon-based micro-electromechanical resonators' IEEE 22ND INTERNATIONAL CONFERENCE ON MICRO ELECTRO MECHANICAL SYSTEMS MEMS 2009 25 January 2009 - 29 January 2009, SORRENTO, ITALY, pages 884 - 887, XP031444436

## Description

The invention relates to a micromechanical resonator in according to the preamble of claim 1.

Thermal drift remains as the main obstacle in the way of Silicon MEMS resonators entering the market of quartz crystal oscillators. Compensation of the drift can be done by replacing part of the resonating volume with material showing opposite sign of thermal drift of resonance frequency than Silicon, such as amorphous SiO₂. Resonator performance is then compromised as compared to purely single crystal resonator.

Conventionally, problems relating to temperature drift of micromechanical resonators have been solved by using a temperature compensating surrounding structure (typically SiO₂) around the basic silicon material or alternatively by using SiO₂ as a part of the structure distributed essentially uniformly in the complete structure. This technology is described in more detail e.g., in publication "Temperature compensation in silicon-based microelectromechanical resonators", F. Schoen et al (ISBN: 978-1-4244-2978-3/09),

A MEMS structure having a compensated resonating member is disclosed in US 7,591,201.

It is an object of the present invention to overcome at least some of the disadvantages of the above-described techniques and to provide an entirely novel type micromechanical resonator and a method for manufacturing a micromechanical resonator.

The goal of the invention is achieved by virtue of locating the thermally compensating second material concentrated in specific places of the resonator.

In one preferred embodiment of the invention a passive compensation of the thermal drift of resonance frequency is used with an optimised way by using the compensating material concentrated in the stress maximum of the resonator. When realised, the commercial significance is vast by providing a method to fabricate MEMS resonators that can potentially compete with the traditional quartz resonator technology. This invention states how to minimize the amount of compensating material by placing it where it is most effective - that is - in the stress maximum (displacement node).

Another preferred embodiment of the invention is based on the use of SiO₂ or TeO₂ in the middle of the vibrating structure.

More specifically, the micromechanical resonator according to the invention is characterized by what is stated in claim 1.

The invention provides significant benefits.

Replacing a fraction of the resonating volume with material with opposite sign thermal drift of resonance frequency reduces the thermal drift. The fraction needed for a given level of reduction is at its smallest when the compensating material is placed at the stress maximum position for the resonance mode being used. Considering a beam vibrating in length extensional mode, placing small amount of compensating material at the ends of the beam i.e. at the stress minimums/displacement maximums, will have a very small effect as the compensating material acts mostly as a passive mass load only, whereas the rest of the beam material acts as spring. If, instead, the compensating material is placed in the middle of the beam, the compensating material acts mainly as the spring having high stress and strain within itself, and compensates the thermal drift more effectively.

Some of the structure embodiments described in this application (such as the fully oxidized spring area) have the important advantage that fabrication tolerances of both the resonant frequency and of thermal coefficient of the resonance frequency are reduced. Fabrication tolerances affect device testing and tuning needs and affect significantly the cost of resonators. In a resonator with a fully oxidized spring area, there is only one interface, the circumference of the laterally relatively *large* oxide area in the middle of the resonator, whose exact location affects fabrication tolerances.

Materials-based thermal compensation method have several advantages over various active electrical compensation schemes: there is no power consumption, they do not suffer from slowness of the servo system, nor is the spectral purity deteriorated.

In the following, the invention will be examined in greater detail with the help of exemplifying embodiments illustrated in the appended drawings, in which
FIG. 1 shows a top view of a resonator using a piezofilm as a part of the component.
FIG. 2a shows as a side view the resonator of figure 1.
FIG. 2b shows as a top view a photograph of an actual component of the resonator of figure 1.
FIG. 3 shows a top view of another resonator using a piezofilm as a part of the component.
FIG. 4 shows as a side view the resonator of figure 3.
FIG. 6 shows as a schematic top view an electrostatically actuated plate resonator .
FIG. 7a shows as a schematic top view a length extensional (LE) beam resonator .
FIG. 7b shows as a schematic side view the length extensional (LE) beam resonator of figure 7a.
FIG. 7c shows as a schematic top view a length extensional (LE) beam resonator in accordance with the invention.
FIG. 7d shows as a schematic side view the length extensional (LE) beam resonator of figure 7c.
FIG. 7e shows as a schematic side view the length extensional (LE) beam resonator in accordance with one alternative solution of the invention.
FIG. 8a shows as a schematic top view a length extensional (LE) beam resonator with a fully filled compensating region in accordance with the invention.
FIG. 8b shows as a schematic side view the length extensional (LE) beam resonator of figure 8a.
FIG. 8c shows as a schematic top view a length extensional (LE) beam resonator with a partially filled compensating region (trenches) in accordance with the invention.
FIG. 8d shows as a schematic side view the length extensional (LE) beam resonator of figure 8c.
FIG. 8e shows as a schematic top view a length extensional (LE) beam resonator with a partially filled compensating region (plugs) in accordance with the invention.
FIG. 8f shows as a schematic side view the length extensional (LE) beam resonator of figure 8e.
Figures 9a-9c show schematically a possible method for fabricating a compensation region structure in accordance with the invention.

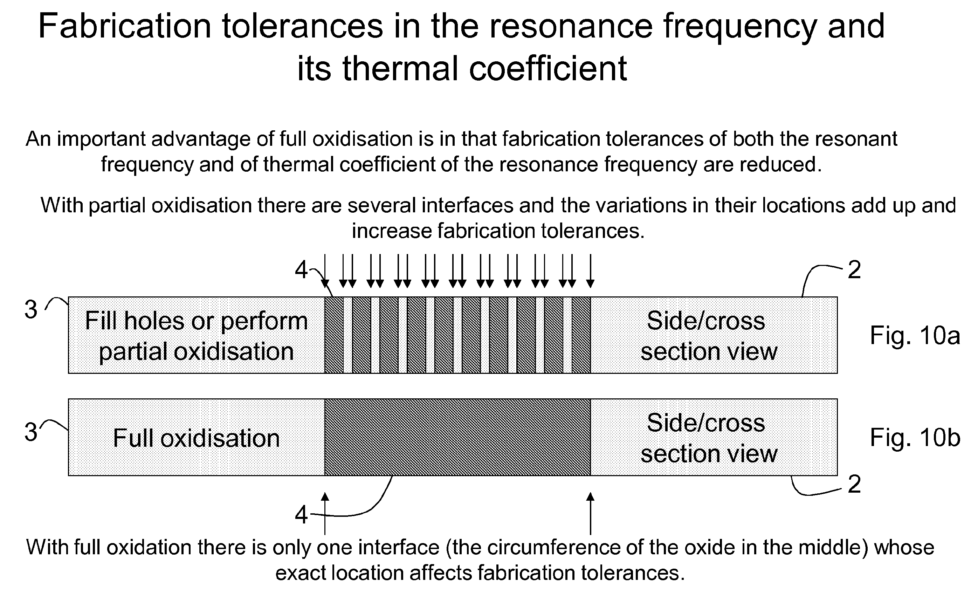

Figures 10a-10b show schematically another possible method for fabricating a compensation region structure in accordance with the invention.
FIG. 11a shows as a schematic top view a square extensional (SE) plate resonator with a fully filled compensating region (trenches).
FIG. 11b shows as a schematic side view the resonator of figure 11a.
FIG. 11c shows as a perspective view the resonator element of figure 11a.

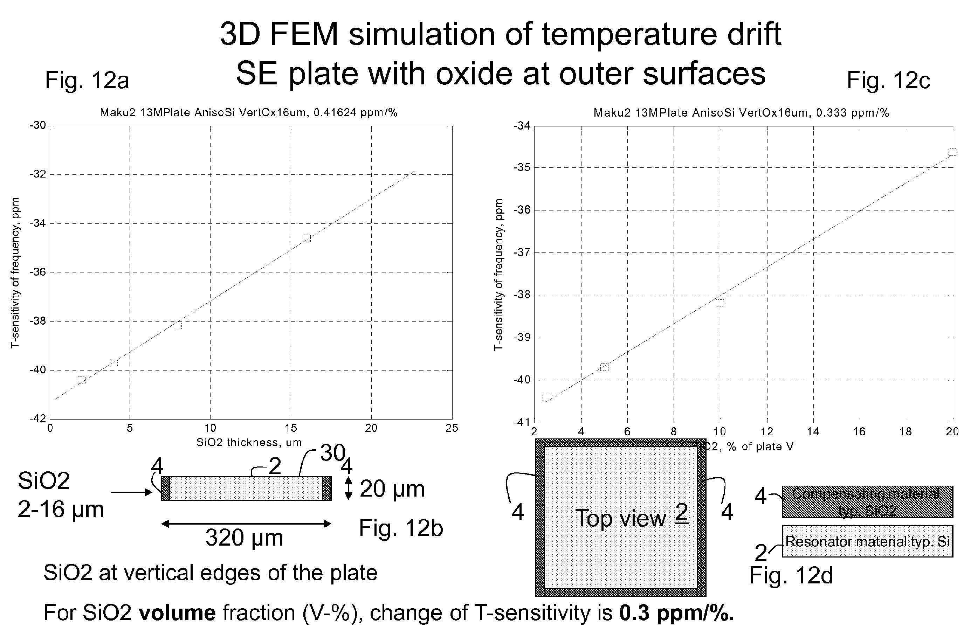

Figures 12a-12d show graphically the influence of the compensating region when positioned at the edges of the resonator.

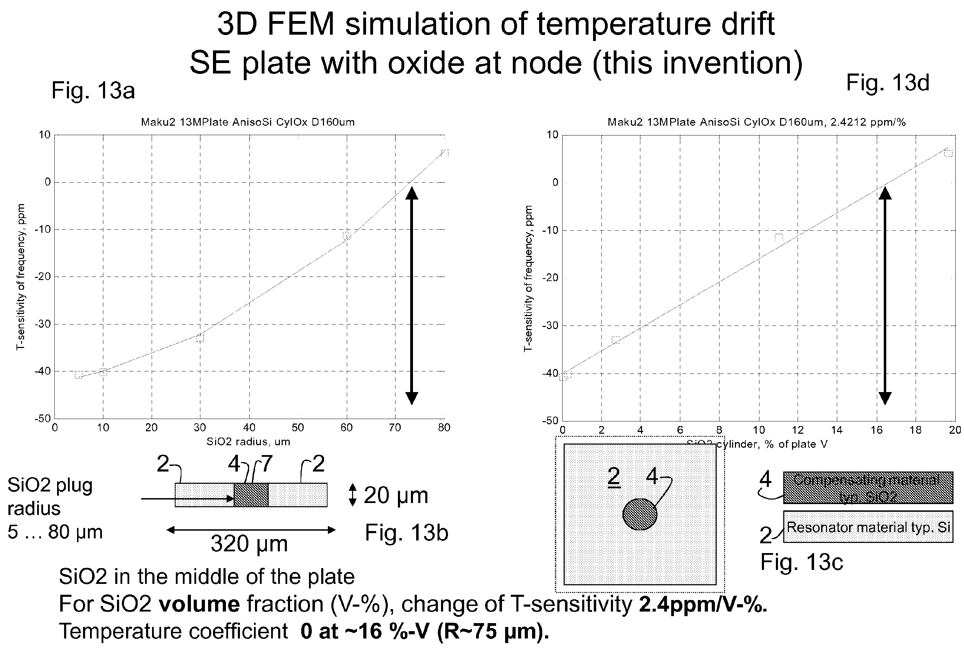

Figures 13a-13d show graphically the influence of the compensating region when positioned at the stress maximul of the resonator.

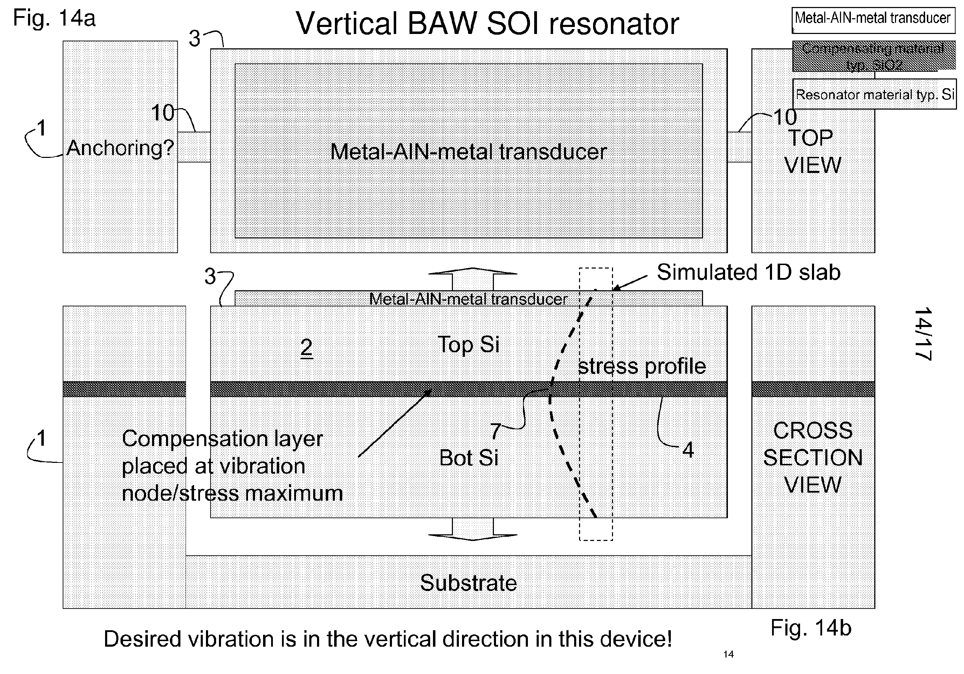

FIG. 14a shows as a schematic top view a vertical BAW SOI resonator with a fylly filled compensating region.
FIG. 14b shows as a schematic side view the resonator of figure 8a.

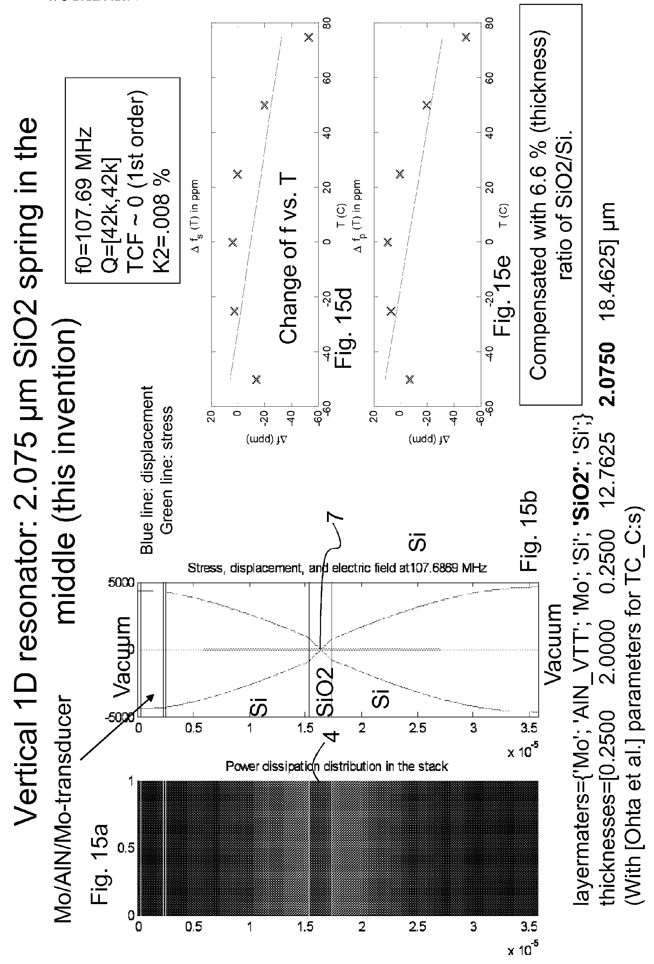

Figures 15a-15e show graphically the influence of the compensating region in a vertical 1D resonator having a 2.075 µm SiO₂ spring in the middle at the stress xaximul of the resonator.

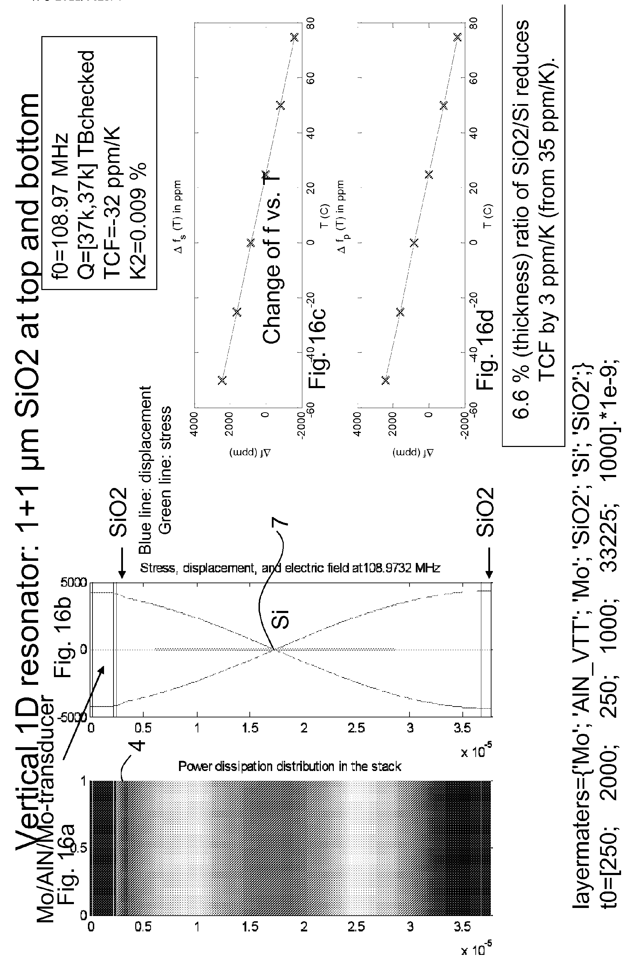

Figures 16a-16e show graphically the influence of the compensating region in a vertical 1D resonator having a SiO₂ layers at top and bottom of the resonator.

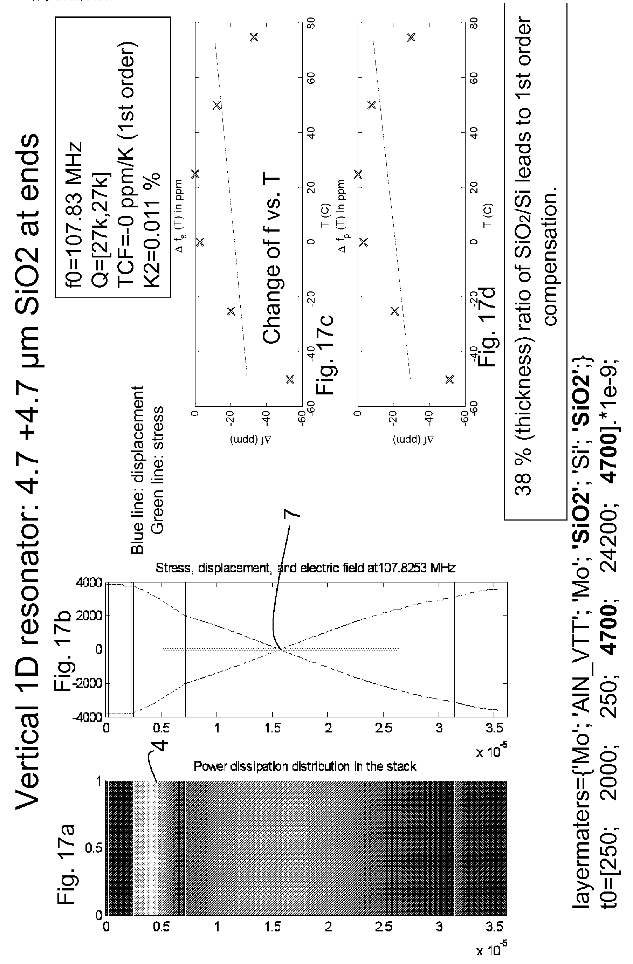

Figures 17a-17e show graphically the influence of the compensating region in a vertical 1D resonator having a µm SiO₂ layers at ends of the resonator.

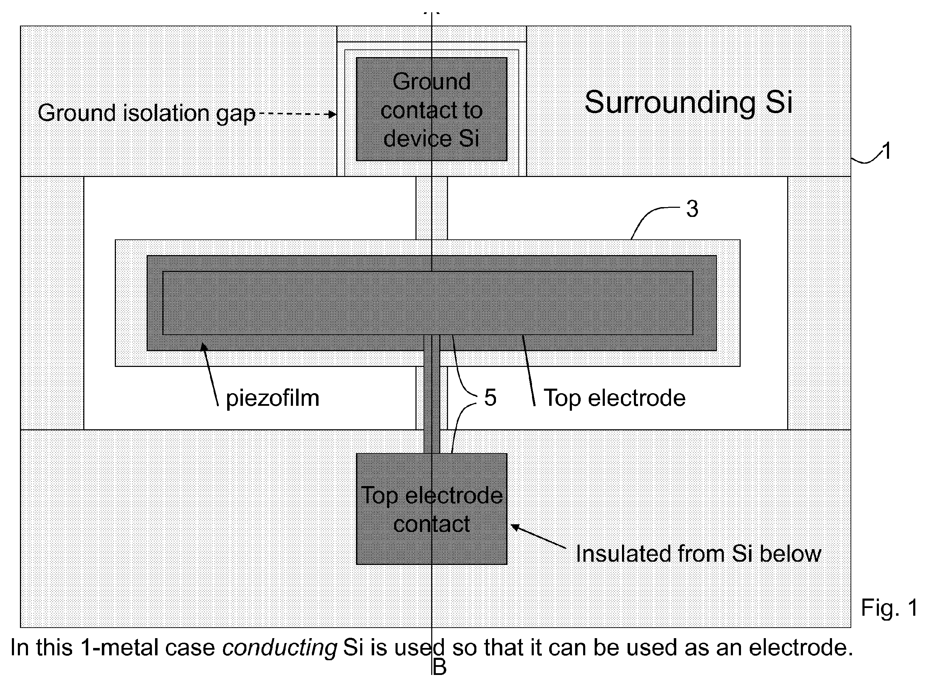

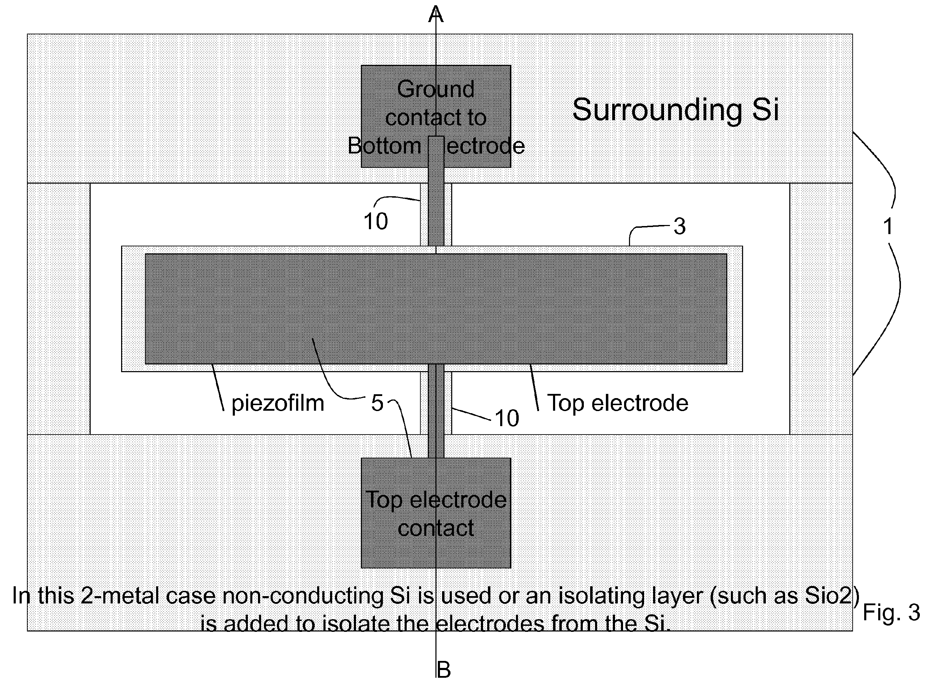

Figures 1 to 4 are related to micromechanical structures, where a resonator 3 is suspended to a supporting structure 1 by anchors 10.

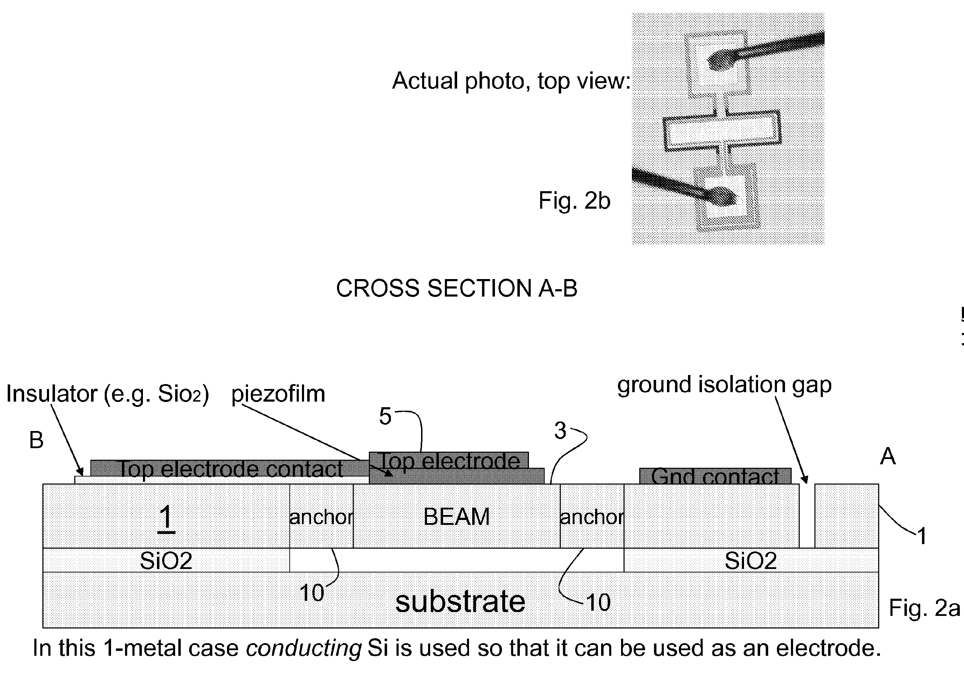

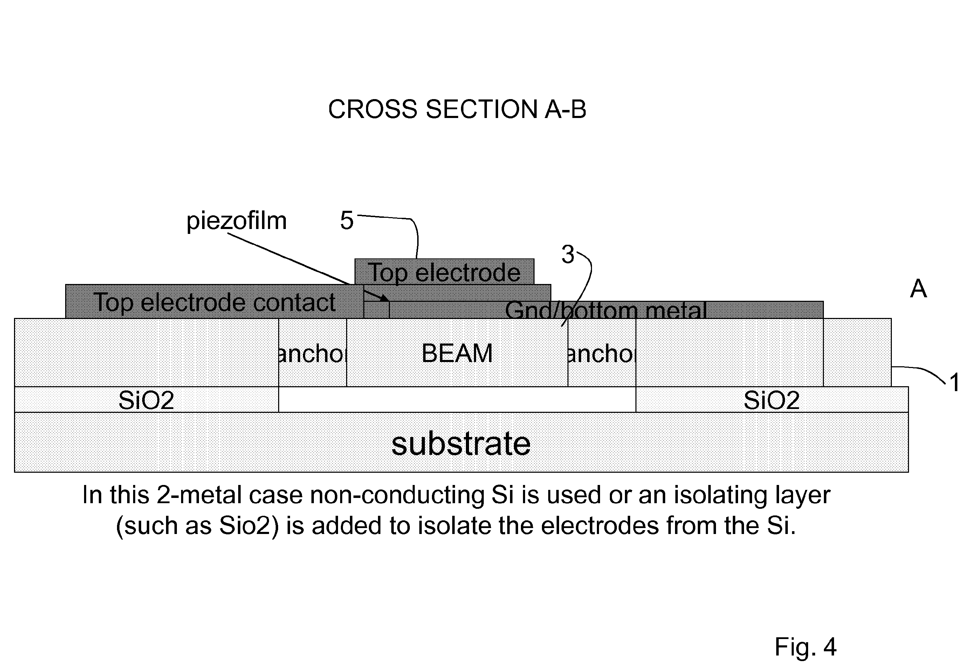

The supporting structure 1 is in one typical embodiment of the invention a silicon device layer of a SOI (Silicon On Insulator) wafer. The dimensions and the suspension of the resonator 3 are such that it vibrates with a specific frequency f₀ when excited by a corresponding electrical signal. A typical length of a beam resonator is 320 µm and height 20 µm. The excitation can be made capacitively by electrodes 5 formed on resonator 3 and on substrate 1 or alternatively by piezoelectric structures of figure 2a or 4.

The electrical signal can be conducted to the structures by electrodes or by making the complete structure conductive to the electrical signal. Typical materials in a resonator are Si for conductive structures and amorphous SiO₂ for isolators. Amorphous TeO₂ is also an alternative material for isolation. Also a SOI (Silicon On Insulator) wafer may be used as a preform for the resonator.

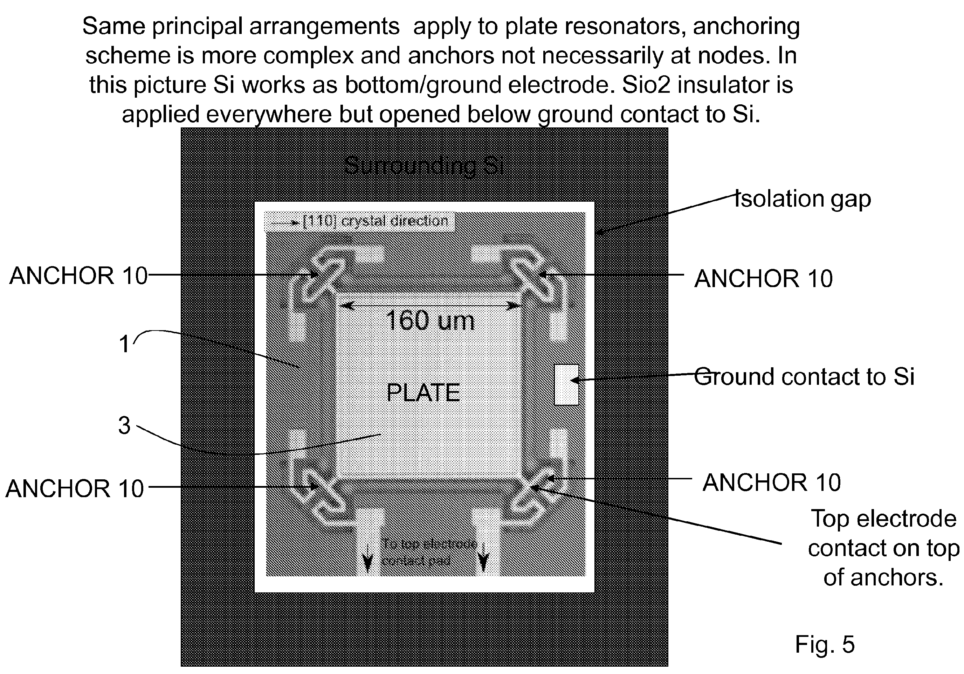

Figure 5 shows a plate resonator. Same principal arrangements apply to plate resonators, anchoring scheme is more complex and anchors not necessarily at nodes. In this picture Si works as bottom/ground electrode. Sio₂ insulator is applied everywhere but opened below ground contact to Si.

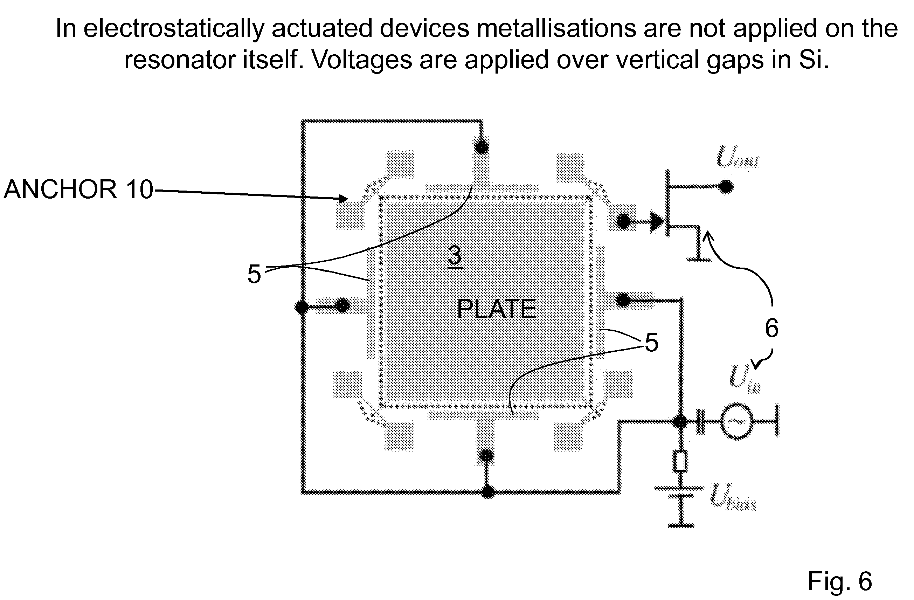

Figure 6 shows an electrostatically actuated device, where metallization are not applied on the resonator itself. Voltages are applied over vertical gaps in Si. An external electrical circuit 6 takes care of the excitation and maintenance of the resonance.

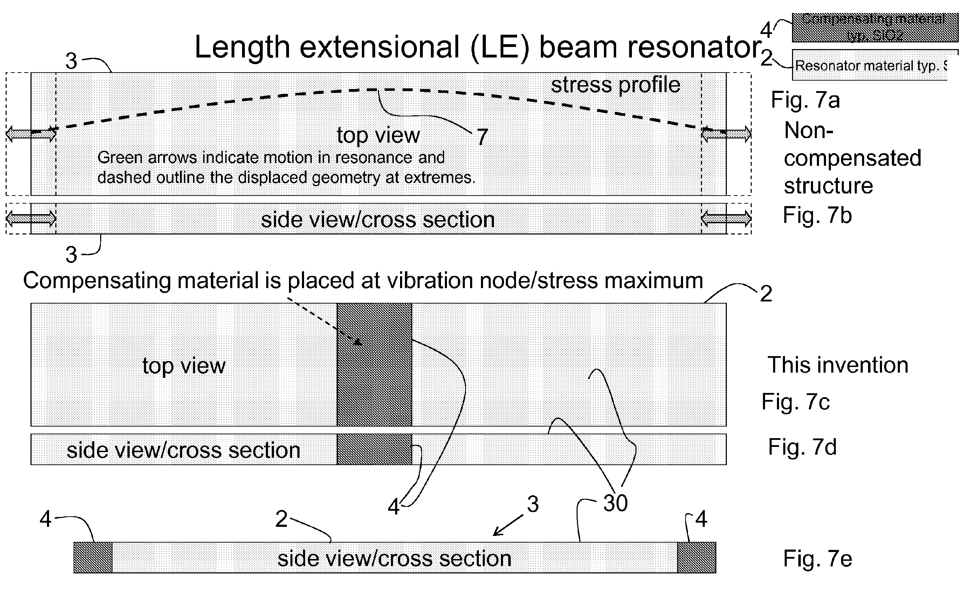

Figures 7a and 7b show the resonator element 3 in more detail and also a stress profile for the resonator is presented with a maximum 7 in the middle of the beam 3.

In figures 7c and 7d is presented the basic solution of the invention where a region of temperature compensating material 4, e.g., SiO₂ or TeO₂ (Tellurium oxide) is positioned at the stress maximum of beam 3. The width of the area 4 is about 10 % of the length of the beam 3, but depending of the basic material and geometry of the beam it may vary in the range of 5 - 30%. Instead of SiO₂ or TeO₂, a glass material with similar thermal properties may be used.

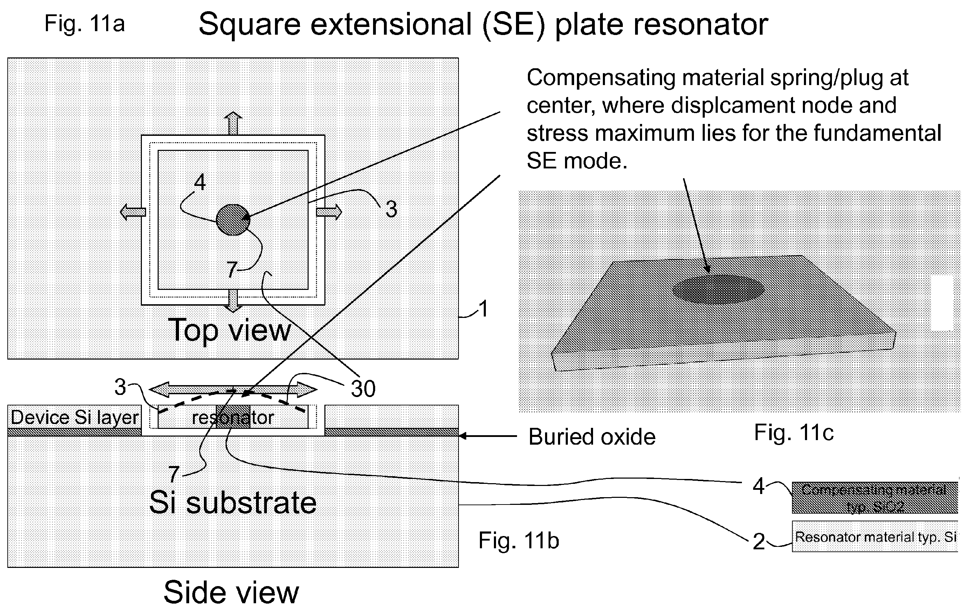

In accordance with figure 7e the second material 4 may be placed at the ends of the resonator 3. In one advantageous solution of the invention the areas of second material are laterally dimensioned to be larger than 10µm. Lateral dimension here means the dimension in the plane of the upper surface 30 of the resonator 3. This upper surface 30 of the resonator 3 is e.g. the surface visible in figure 7c or alternatively in figures 11a and 11b. By this dimensioning the problems with production tolerances may be minimized. This way dimensioning is applicable also for solutions of figures 7a and 7b if the other dimensioning rules, e.g., for f₀ are met.

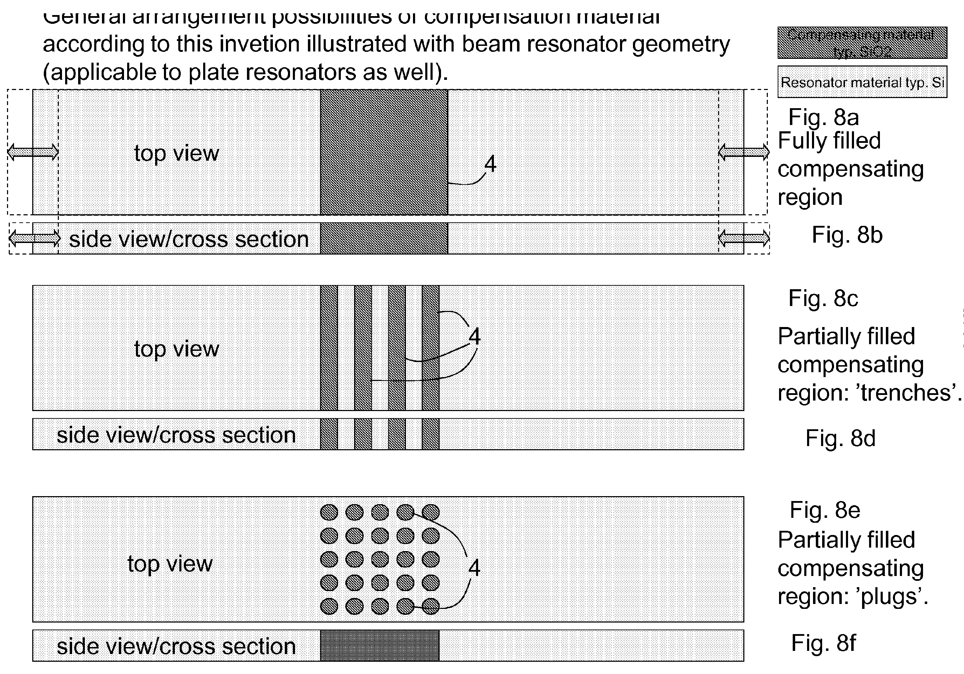

Figures 8a and 8b correspond to solution of figures 7a-7d. Figures 8c-8d show a partially filled compensating region 4 formed by transverse trenches.

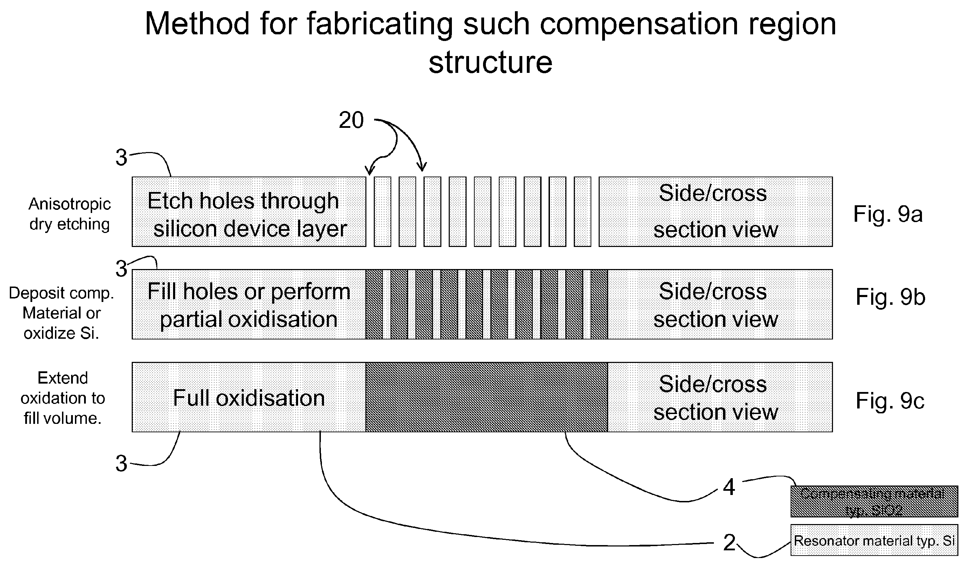

In figures 9a-9c is described in more detail a process for manufacturing the resonator. In accordance with figure 9a holes 20 are etched through silicon device layer (e.g., anisotropic dry etching). This is a standard etching process known by the man skilled in the art. In figure 9b holes are filled by a deposition phase or alternatively a partial oxidization is made. In stage of figure 9c oxidation is extended to fill the complete volume.

In other words the typical embodiments of the invention are manufactured by creating, an oxide or region of partially oxide (or other compensating material) 4 in the middle of a length extensional beam resonator 3.

This invention has focused on finding thermally compensated resonator structures which minimize the amount of oxide material by placing the oxide in a position with the largest effect on the thermal coefficient. Simulations on 1-D length-extensional resonators show that by placing the oxide at the end of the extending bars one needs as much as 38% volume ratio of the oxide. (The actual number is of course sensitive to the materials parameters which do have some uncertainty.) It should be noted that also this solution is a good solution if the large amount of oxide does not have any significant adverse effects. Assuming again the oxide area is "fully oxidized" (see the discussion above), the fabrication tolerances in the exact location of the oxide-silicon interface, do not have a large effect on the value of the resonance frequency of the value of the thermal coefficient. From the lithography point of view, it is in fact advantageous that the volumes of the silicon and the oxide would be as equal as possible. What differentiates such a structure from previously described solutions is again that the oxide forms one large volume (with all dimensions much larger than 1 micrometer).

In this application the resonator 3 means the actual mechanically vibrating element and by the supporting structure 1 is meant the construction to which the resonator is suspended to.

The second material 4, also called here compensating material 4, has different thermal properties than the first material 2 of the supporting structure 1. In the preferred embodiment of the invention the thermal dependence of the sound velocity in the material is opposite to each other in these two structures. This condition is met for example to the following pairs:
First material: Si
Second material: amorphous SiO₂ or amorphous TeO₂ or glass with suitable thermal properites.

For the man skilled in the art it is clear that a resonator may have several tension maximums at the specific frequency f₀, and then the method will be applied to all of them.

## Claims

1. Micromechanical resonator comprising
• a supporting structure (1) of a first material (2),
• a length-extensional beam resonator (3) suspended from the supporting structure (1), the resonator (3) being at least partially of the same material (2) as the supporting structure and dimensioned for resonation at a specific frequency f₀,
• coupling means (5) for initiating, maintaining and coupling the resonation of the resonator (3) to an external circuit (6), and
• the resonator (3) including a second material (4), the thermal properties of which being different from the first material (2),
**characterized in that**
• the second material (4) is located concentrated in the area of resonator (3) where the resonator's stress profile has a maximum (7) at the specific frequency f₀, and
• the parts of the resonator being of the second material is dimensioned laterally to be in a range between 5 % - 30 % of the length of the resonator (3).

2. A resonator in accordance with claim 1, **characterized in that** the parts of the resonator (3) of the second material (4) are at the lateral ends of the resonator (3).

3. A resonator in accordance with any previous claim, **characterized in that** the first material (2) is silicon (Si) and the second material (4) is silicon oxide (SiO₂) or Tellurium oxide (TeO₂) or glass.

4. A resonator in accordance with any previous claim, **characterized in that** the resonator (3) is suspended in its middle from the supporting structure (1).

5. A resonator in accordance with any previous claim or their combination, **characterized in that**
the parts of the second material (4) placed at the stress maximum are only partially filling the first material as trenches or plugs.

6. A resonator in accordance with any previous claim or their combination, **characterized in that** the thermal dependence of the sound velocity of the first material (3) is opposite to that of the second material (4).

## Patentansprüche

1. Mikromechanischer Resonator, umfassend:
- eine Trägerstruktur (1) aus einem ersten Material (2),
- einen an der der Trägerstruktur (1) aufgehängten längs ausgedehnten Strahlenresonator (3), wobei der Resonator (3) zumindest teilweise aus demselben Material (2) wie die Trägerstruktur ist und zum Mitschwingen bei einer bestimmten Frequenz f₀ dimensioniert ist,
- eine Kopplungseinrichtung (5) zum Initiieren, Aufrechterhalten und Koppeln des Mitschwingens des Resonators (3) an einen externen Schaltkreis (6), und
- wobei der Resonator (3) ein zweites Material (4) enthält, dessen thermische Eigenschaften sich von denen des ersten Materials (2) unterscheiden,
**dadurch gekennzeichnet, dass**
- das zweite Material (4) konzentriert in dem Bereich des Resonators (3) angeordnet, in dem das Stressprofil des Resonators ein Maximum (7) bei der bestimmten Frequenz f₀ aufweist, und
- die Teile des Resonators, die aus dem zweiten Material sind, lateral derart dimensioniert sind, dass sie in einem Bereich zwischen 5% - 30% der Länge des Resonators (3) sind.

2. Resonator nach Anspruch 1, **dadurch gekennzeichnet, dass** die Teile des Resonators (3), die aus dem zweiten Material (4) sind, sich an den lateralen Enden des Resonators (3) befinden.

3. Resonator nach einem der vorhergehenden Ansprüche, **dadurch gekennzeichnet, dass** das erste Material (2) Silikon (Si) und das zweite Material (4) Silikonoxid (SiO₂) oder Telluroxid (TeO₂) oder Glas ist.

4. Resonator nach einem der vorhergehenden Ansprüche, **dadurch gekennzeichnet, dass** der Resonator (3) an seiner Mitte an der der Trägerstruktur (1) aufgehängt ist.

5. Resonator nach einem der vorhergehenden Ansprüche oder einer Kombination daraus, **dadurch gekennzeichnet, dass** die an dem Stressmaximum angeordneten Teile des zweiten Materials (4) das erste Material nur teilweise als Graben oder Stopfen füllen.

6. Resonator nach einem der vorhergehenden Ansprüche oder einer Kombination daraus, **dadurch gekennzeichnet, dass** die thermische Abhängigkeit der akustischen Geschwindigkeit des ersten Materials (3) entgegengesetzt zu der des zweiten Materials (4) ist.

## Revendications

1. Résonateur micromécanique comprenant :
- une structure de support (1) dans un premier matériau (2),
- un résonateur à faisceau à extension longitudinale (3) suspendu à la structure de support (1), le résonateur (3) étant au moins en partie du même matériau (2) que la structure de support et dimensionné pour émettre une résonance à une fréquence spécifique f₀,
- des moyens de couplage (5) pour lancer, maintenir et coupler la résonance du résonateur (3) à un circuit externe (6), et
- le résonateur (3) comprenant un second matériau (4), dont les propriétés thermiques sont différentes de celles du premier matériau (2),
**caractérisé en ce que**
- le second matériau (4) est concentré dans la zone du résonateur (3) où le profil de tension du résonateur possède un maximum (7) à la fréquence spécifique f₀, et
- les parties du résonateur constituées du second matériau sont dimensionnées latéralement pour se situer dans une plage de 5 % à 30 % de la longueur du résonateur (3).

2. Résonateur selon la revendication 1, **caractérisé en ce que** les parties du résonateur (3) constituées du second matériau (4) se trouvent aux extrémités latérales du résonateur (3).

3. Résonateur selon l'une quelconque des revendications précédentes, **caractérisé en ce que** le premier matériau (2) est du silicium (Si) et le second matériau (4) est de l'oxyde de silicium (SiO₂) ou de l'oxyde de tellure (TeO₂) ou du verre.

4. Résonateur selon l'une quelconque des revendications précédentes, **caractérisé en ce que** le résonateur (3) est suspendu par son centre à la structure de support (1).

5. Résonateur selon l'une quelconque des revendications précédentes ou leur combinaison, **caractérisé en ce que** les parties en second matériau (4) placées à la tension maximale ne remplissent qu'en partie le premier matériau sous forme de sillons ou de vides.

6. Résonateur selon l'une quelconque des revendications précédentes ou leur combinaison, **caractérisé en ce que** la dépendance thermique de la vitesse du son du premier matériau (3) est opposée à celle du second matériau (4).
